Europäisches Patentamt

European Patent Office

Office européen des brevets

(19)

(11) **EP 0 772 267 A1**

(12) **EUROPEAN PATENT APPLICATION**

(43) Date of publication:
07.05.1997 Bulletin 1997/19

(51) Int. Cl.$^6$: **H01S 3/085**, H01S 3/19

(21) Application number: 96117523.9

(22) Date of filing: 31.10.1996

(84) Designated Contracting States:
DE FR NL

(30) Priority: 31.10.1995 JP 308357/95

(71) Applicant: NEC CORPORATION
Tokyo (JP)

(72) Inventor: Furushima, Yuji
Minato-ku, Tokyo (JP)

(74) Representative: Baronetzky, Klaus, Dipl.-Ing. et al
Patentanwälte
Dipl.-Ing. R. Splanemann, Dr. B. Reitzner, Dipl.-Ing. K. Baronetzky
Tal 13
80331 München (DE)

(54) **Laser diode device**

(57) Disclosed is a 1.3 µm band λ/4 shifted distributed-feedback type laser diode device, which has: an active layer with $In_{1-x}Ga_xAs_{1-y}P_y$ $(0 \leq x < 1, 0 \leq y < 1)$ strained multiple quantum wells; wherein a resonator length of 300 to 600 µm, a detuned quantity at room temperature of -15 to +15 nm and a quantum well number of 8 to 15 or a light confinement factor to quantum well layer of 3 to 10% are satisfied.

*FIG.6*

| | |
|---|---|
| 11 n-InP SUBSTRATE | 15 λ/4 SHIFT DIFFRACTION GRATING |
| 12 STRAINED MQW LAYER | 16 n-ELECTRODE |
| 13 BAFFER LAYER | 17 NON-REFRECTING COATING |
| 14 DC-PBH CURRENT CONSTRICTION STRUCTURE | 18 p-PAD ELECTRODE |

EP 0 772 267 A1

# Description

## FIELD OF THE INVENTION

This invention relates to a semiconductor device used as a light source in an optical communication system and more particularly to, a laser diode device which is used in a wide temperature range.

## BACKGROUND OF THE INVENTION

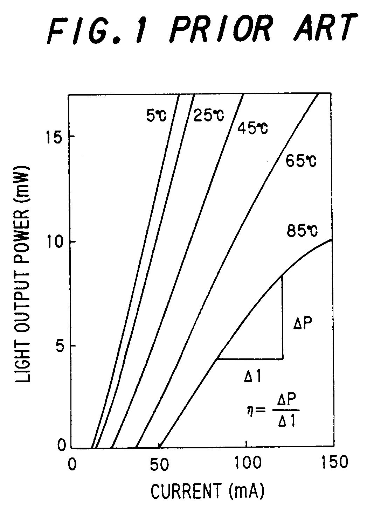

Along with the development in optical communication system, a semiconductor optical device with a stable output characteristic in a wide temperature range has been sought. As a light source for optical communication, laser diode(LD) devices are generally used while a light emitting diode(LED) is used for relatively short distance communication. However, the output characteristic of a LD device itself is highly varied depending on the surrounding temperature, for example, as shown in FIG.1, a threshold current Ith increases and a slope efficiency η decreases in a higher temperature. When a LD device is used as a light emitting source for optical communication, a bias current near to the threshold current is generally applied and a pulse current is further superposed in order to generate an optical pulse signal. Here, the peak value of the optical pulse is required to be constant as long as possible since it affects the dynamic range etc. of a receiving device.

Since the LD devices have the temperature-dependency in output characteristic, in general, they use a temperature control device for keeping the LD temperature to be constant. However, the temperature control device is expensive and increases the size of the semiconductor optical device and the consumed power. On the other hand, when the temperature control device is not used, since the slope efficiency η is highly decreased with the increase in temperature, the DC bias current has to be controlled and the superposed pulse current has to be adjusted in order to keep the peak value of the optical pulse to be constant. Thus, the composition and control of the modulator circuit will be complicated with the increase in the temperature-dependency in optical output characteristic of a LD device.

As described above, since semiconductor optical devices require the temperature control device and the complicated input signal control circuit, an improvement in the temperature characteristic of the semiconductor optical devices themselves is desired to realize the miniaturization and low cost thereof. In general, a LD device for optical communication system is required to operate in a temperature range of -40 to +85 °C, for example, as described in "Reliability Assurance Practices for Optoelectronic Devices in Loop Applications", Bellcore, TA-TSY-00983, Issue 1, January 1990. Further, as an example of high-temperature light output characteristic, required are a threshold current at 85°C less than 50 mA, an operating current in 5mW output less than 80 mA and a slope efficiency fall ratio with temperature change 25 to 85 °C less than 3 dB(50%). Recently, in a Fabry-Perot resonator-type LD( hereinafter referred to as 'FP-LD'), which is used for a long distance transmission longer than several kilometers and with a relatively low transmission rate less than 155 Mb/s or used for a relatively short distance transmission shorter than 1 km and with a high transmission rate, for example, 1 Gb/s, a device which can be operated in the temperature range -40 to +85 °C is realized by introducing a multiple quantum well( hereinafter referred to as 'MQW') active layer structure or a strained MQW active layer structure or improving the current constriction structure.

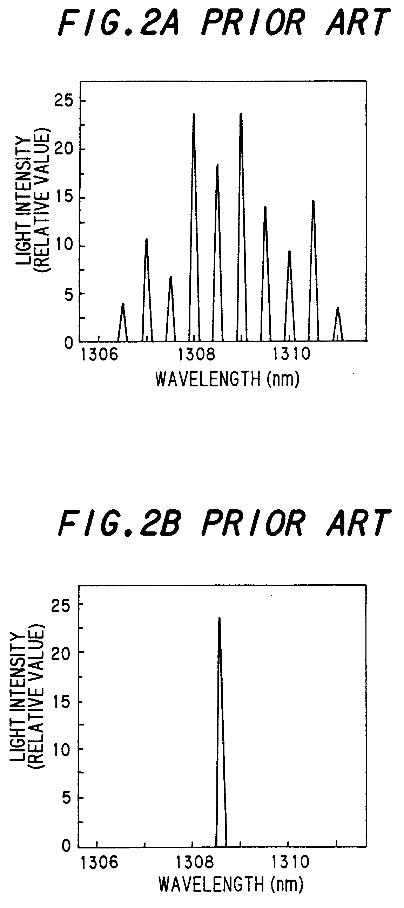

However, in a FP-LD which oscillates in multiple longitudinal mode as shown in FIG.2A, since the signal waveform is degraded during the long distance transmission due to the spread of oscillation wavelength spectrum, it cannot be used for a high-speed long distance transmission higher than several hundreds Mb/s. Because of this, in general, used is a distributed-feedback laser diode( hereinafter referred to as 'DFB-LD') which oscillates, as shown in FIG.2B, in single axis mode at a wavelength determined by a diffraction grating provided in the device. However, due to the temperature-dependency in detuned quantity which is explained below, it is difficult for DFB-LD to get stable light output and single axis mode oscillation characteristics in the wide temperature range of -40 to 85°C. DFB-LD oscillates in single axis mode at a Bragg wavelength $\lambda$Bragg=2neff $\Lambda$ which is determined by a period $\Lambda$ of a diffraction grating provided in the device and an effective refractive index neff of an optical waveguide layer to laser light waveguided in the LD device. The oscillation wavelength $\lambda$Bragg is lengthened at the rate of about 0.09 nm/°C with the increase in the temperature of the active layer.

On the other hand, due to the temperature dependence of the band structure of the LD active layer, a wavelength where optical gain is maximum, i.e., a gain peak wavelength $\lambda$GP, has a temperature-dependency and is lengthened at the rate of 3 to 6 nm/°C with the increase in the temperature of the active layer. Here, since the gain peak wavelength $\lambda$GP is also changed depending on the amount of current flown into the device, the gain wavelength $\lambda$GP in the present invention is defined as a gain peak wavelength when an amount of current 0.9 times the oscillation threshold current Ith is flown into it.

The difference between the Bragg wavelength $\lambda$Bragg and the gain peak wavelength $\lambda$GP, i.e., a detuned quantity $\Delta\lambda$=$\lambda$Bragg-$\lambda$GP , highly influences the light output characteristic and high-speed modulation characteristic of DFB-LD and is one of most important parameters when DFB-LD is designed to operate at a constant temperature. Due to the difference between the shift quantities of $\lambda$Bragg and $\lambda$GP to the temperature change as described above, the detuned quantity $\Delta\lambda$ has temperature-dependency. Therefore, the wide temperature range operation of DFB-LD becomes very difficult.

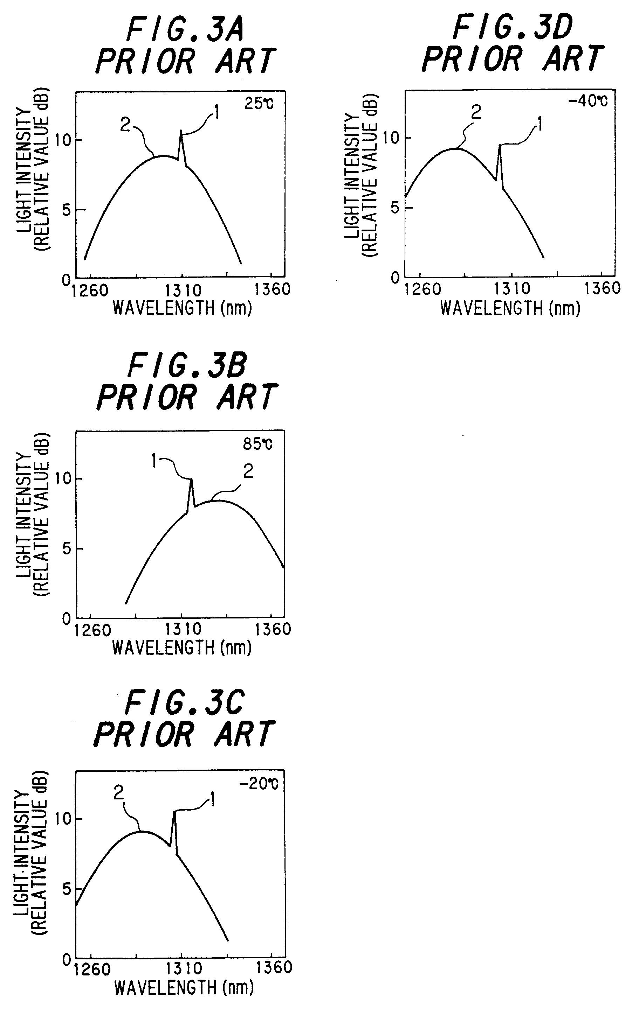

FIGS.3A to 3D show a temperature-dependency in spectrum before an oscillation threshold when a current 0.9 times the oscillation threshold current Ith is applied to DFB-LD with a detuned quantity of +10 nm at 25°C(hereinafter also referred to as 'room temperature'), where the detuned quantity $\Delta\lambda$ at 85°C is -8nm that is around 20 nm shifted to the negative side. At lower temperatures, the detuned quantity $\Delta\lambda$ is +18 nm at -20°C and reaches +30nm at -40°C. Thus, the increase in the absolute value $|\Delta\lambda|$ of the detuned quantity becomes a big problem when DFB-LD oscillates in single axis mode at the Bragg wavelength.

Meanwhile, currently used DFB-LDs include a device that the diffraction grating is not provided with phase shift and a device that the diffraction grating is provided with phase shift. In the former device(hereinafter referred to as 'uniform diffraction grating DFB-LD'), in general, the front end surface reflection factor is set to be less than 1% and the rear end surface reflection factor more than 70 or 90 %, whereby the light quantity output from the front side, i.e., the front slope efficiency, is increased. However, due to the relatively high rear end surface reflection factor, there is a problem that Fabry-Perot mode( hereinafter referred to as 'FP mode') oscillation cannot be sufficiently suppressed when the detuned quantity is increased. If it is operated only in a relatively narrow temperature range, the FP mode suppression characteristic is not so important. However, since the detuned quantity $\Delta\lambda$ has a high temperature-dependency as described above, it is very difficult for a sufficient FP mode suppression ratio(herein after referred to as 'FMSR') to be obtained in a wide temperature range.

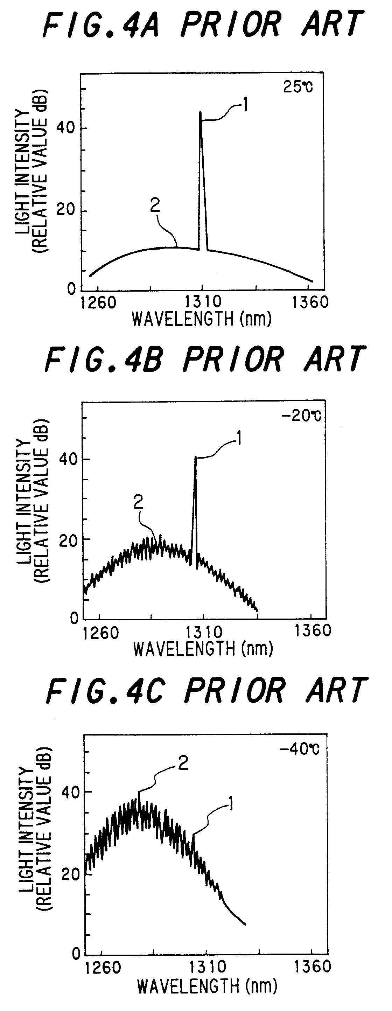

For example, in case of the uniform diffraction grating DFB-LB with a front reflection factor less than 1% and a rear reflection factor more than 75%, as shown in FIGS.4A to 4C, due to the increase in the detuned quantity at low temperature, FMSR at -20°C($\Delta\lambda$=+18nm) is reduced to 20 dB from 35 dB at room temperature, and further, as shown in FIG.4C, at -40°C($\Delta\lambda$=+30 nm) the FP mode oscillation is predominant over the DFB mode. Such reduction of FMSR causes the deterioration in transmission characteristic, i.e., receiving sensitivity, and the increase in bit error rate. Furthermore, when the FP mode oscillation is predominant over the DFB mode, it does not function as DFB-LD and cannot be used as a light source for the long distance high-speed optical communication system where a transmission rate more than several hundreds Mb/s, a transmission distance more than several tens kilometers are required.

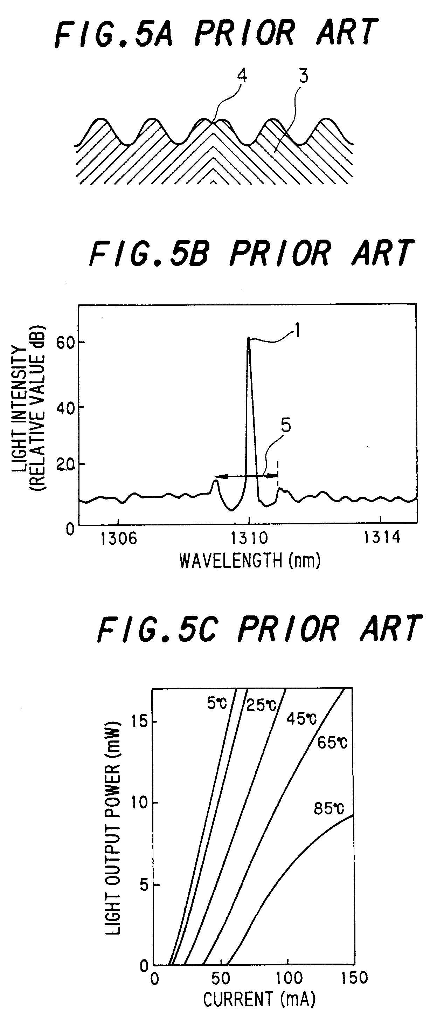

On the other hand, in the latter devices that the diffraction grating is provided with phase shift, as shown in FIG.5A, practically used is a device that is provided with phase shift of 1/4 near the central portion in the direction of diffraction grating axis( hereinafter referred to as '$\lambda$/4 shifted DFB-LD'). In the $\lambda$/4 shifted DFB-LD, since both the end surfaces of the device are of non-reflecting coating with a reflection factor less than 1%, a stable single axis mode oscillation as shown in FIG.5B can be obtained at the Bragg wavelength near the center of the stop band by the diffraction grating. Furthermore, since both the end surfaces are of non-reflecting coating, FP mode oscillation can be suppressed, therefore, even in a device with the same room temperature detuned quantity as the above-mentioned uniform diffraction grating DFB-LD, FMSR at - 20°C($\Delta\lambda$=+18 nm ) can be kept more than 50 dB, which is the same level as in case of room temperature, and even FMSR at - 40°C($\Delta\lambda$=+30 nm ) can be kept more than 30 dB.

However, since it is impossible to greatly change the front-rear output ratio by varying the front and rear end surface factors, the high output power operation is difficult particularly in high temperature. In fact, it has not been reported that a stable operation of $\lambda$/4 shifted DFB-LD can be realized at high temperature such as 85°C. For example, even in a device in which the high temperature characteristic is improved by introducing a InGaAsP strained MQW into an active layer and which has a resonator length of 300 $\mu$m, a detuned quantity of -10 nm and seven quantum wells(light confinement factor to MQW of 2.5%), the temperature-dependency in the current-light output power characteristic is as shown in FIG.5C, where the slope efficiency fall ratio due to the increase in temperature from room temperature to 85°C is so big as to be 3.5 dB.

As described above, in DFB-LD, since the gain fall in high temperature occurs similarly to FP-LD and the variation of oscillation wavelength gain and FMSR due to the change of detuned quantity $\Delta\lambda$ are significant, it is very difficult for it to get a stable light output characteristic and high-speed modulation characteristic in a wide temperature range. So far, only one report is disclosed by Yamamoto et al., "High Temperature Operation of 1.3 $\mu$m Strained-MQW-CBPBH-DFB-LD grown by all MOCVD" , EICS autumn meeting, preview paper C-302 (1994), where an uniform diffraction grating DFB-LD is operated at a modulation speed of 622.08 Mb/s and a temperature range from -20 to 85°C.

In the conventional DFB-LD, which is used as a light source for long-distance high-speed optical communication system which requires a transmission rate of more than several hundreds Mb/s( normally 622.08 Mb/s or 2.48832 Gb/s) and a transmission distance of more than several tens km( normally more than 40 km), a temperature control apparatus to keep the LD temperature to be constant is required. Thus, the temperature control apparatus seriously prevent the semiconductor optical device from having low cost, small size and low consumed power. The reason is that DFB-LD for long-distance and high-speed optical communication system has a very high temperature-dependency in light output power, oscillation spectrum and high-speed modulation characteristics and therefore it is impossible for it to achieve a stable single axis mode oscillation in a temperature range of - 40 to +85°C and good light output characteristics at high temperature, i.e., a threshold current at 85°C less than 50 mA, an operating current in 5mW outputting less than 80 mA and a slope efficiency fall ratio to temperature change of 25 to 85°C less than 3 dB.

SUMMARY OF THE INVENTION

Accordingly, it is an object of the invention to provide a laser diode device which has good light output and modulation characteristics in a wide temperature range and can be used as a light source for long-distance high-speed optical communication system which requires a transmission rate of more than several hundreds Mb/s( normally 622.08 Mb/s or 2.48832 Gb/s) and a transmission distance of more than several tens km( normally more than 40 km).

According to the invention, a 1.3 μm band λ/4 shifted distributed-feedback type laser diode device, comprises:

an active layer with $In_{1-x}GaxAs_{1-y}Py$ (0≤x<1, 0≤y<1)strained multiple quantum wells;

wherein a resonator length of said laser diode device is 300 to 600 μm, a detuned quantity at room temperature is -15 to +15 nm and, either a quantum well number is 8 to 15 or a light confinement factor to said quantum well layers is 3 to 10%.

According to another aspect of the invention, a 1.3 μm band λ/4 shifted distributed-feedback type laser diode device, comprises:

an active layer with $In_{1-x}GaxAs_{1-y}Py$ (0≤x<1, 0≤y<1) strained multiple quantum wells;

wherein a resonator length of said laser diode device is 400 to 500 μm, a detuned quantity at room temperature is -10 to +10 nm and, either a quantum well number is 10 to 12 or a light confinement factor to said quantum well layers is 5 to 8%.

According to further aspect of the invention, a 1.3 μm band λ/4 shifted distributed-feedback type laser diode device, comprises:

an active layer with AlGaInAs strained multiple quantum wells;

wherein a resonator length of said laser diode device is 250 to 600 μm, a detuned quantity at room temperature is -20 to +15 nm and, either a quantum well number is 5 to 15 or a light confinement factor to said quantum well layers is 2 to 10%.

According to still further aspect of the invention, a 1.3 μm band λ/4 shifted distributed-feedback type laser diode device, comprises:

an active layer with AlGaInAs strained multiple quantum wells;

wherein a resonator length of said laser diode device is 300 to 500 μm, a detuned quantity at room temperature is -15 to +10 nm and, either a quantum well number is 6 to 12 or a light confinement factor to said quantum well layers is 2.5 to 8%.

In the invention, $In_{1-x}GaxAs_{1-y}Py$ includes $InAs_{1-y}Py$, where "x" is zero.

Meanwhile, in the present invention, the quantum well number and the light confinement factor to quantum well layer are alternatively defined. This is because both the parameters are not independent and are related with each other, and because it is found that the influence to a device characteristic is predominant in Γw rather than Nw which is easy to intuitionally understand. For example, the characteristic of a device with quantum well width of 60Å, Nw=7 and Γw=6% is near to that of a device with Nw=10, Γw=6% rather than a device with Nw=7, Γw=4%, both in case of a quantum well width of 40Å. This is because an amount of optical gain which determines various characteristics is proportional to Γw.

On the other hand, in the present invention, method for making a device, position of λ/4 shift diffraction grating, structure of an active layer, strain level of quantum well layer and composition of current constriction structure are not limited. The value of (coupling coefficient of diffraction grating) X (resonator length) which highly affects a single mode yield, current-light output characteristic or the like in DFB-LD should be designed so that a single mode yield in λ/4 shifted DFB-LD is not significantly deteriorated, for example, within about 2 to 3.

BRIEF DESCRIPTION OF THE DRAWINGS

The invention will be explained in more detail in conjunction with the appended drawings, wherein:

FIG.1 shows a temperature dependency of a current-light output power characteristic in a conventional laser diode,

FIGS.2A and 2B show a longitudinal multiple mode oscillation of a conventional FP-LD and a single longitudinal mode oscillation of a conventional DFB-LD, respectively,

FIGS.3A to 3D show a temperature-dependency in spectrum before an oscillation threshold of a conventional DFB-LD,

FIGS.4A to 4C show a deterioration of FP mode suppression characteristic at low temperature in a conventional uniform diffraction grating DFB-LD,

FIGS.5A to 5C show a λ/4 shift diffraction grating, an example of a stable single axis mode oscillation near the center of stopband, and a temperature-dependency of a current-light output characteristic, respectively, in a conventional λ/4 shifted DFB-LD,

FIG.6 is a perspective sectional view showing a laser diode device in a first preferred embodiment according to the invention,

FIGS.7A and 7B show quantum well number dependencies of slope efficiency fall ratio, room temperature detuned quantity and threshold current, operating current in light output, respectively, in the first embodiment,

FIGS.8A and 8B show resonator length dependencies of slope efficiency fall ratio and threshold current, operating current in light output, respectively, in the first embodiment

FIGS.9A and 9B show a temperature-dependency of FP mode suppression ratio and a room temperature detuned quantity dependency, respectively, in the first embodiment,

FIGS.10A to 10D show a temperature characteristic of a current-light output characteristic and typical examples of transmission characteristic in the first embodiment,

FIGS.11A to 11C show dependencies on resonator length, quantum well number and room temperature detuned quantity of a relaxation oscillation frequency in the first embodiment,

FIG.12 shows a temperature-dependency of a relaxation oscillation frequency in the first embodiment,

FIGS.13A to 13C show a temperature characteristic of a current-light output characteristic and typical examples of transmission characteristic in the first embodiment,

FIG.14 shows a temperature characteristic of a current-light output characteristic in a laser diode device in a second preferred embodiment according to the invention,

FIGS.15A and 15B show band the difference of discontinuous quantities of InGaAsP quantum well and AlGaInAs quantum well, and

FIG.16 shows a temperature characteristic of a current-light output characteristic in a laser diode device in a third preferred embodiment according to the invention.

## DESCRIPTION OF THE PREFERRED EMBODIMENTS

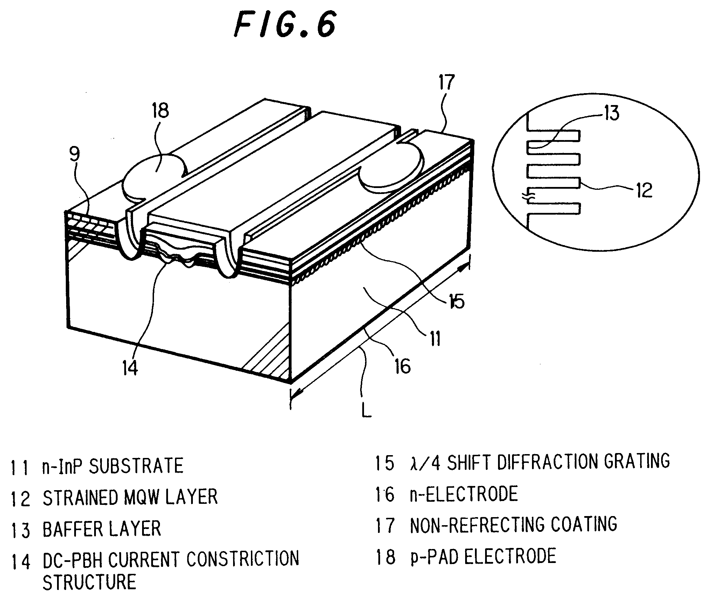

A laser diode device in the first preferred embodiment according to the invention will be explained in FIGS.6 to 13C.

In the first embodiment, a $\lambda/4$ shifted DFB-LD which has a current constriction structure with DC-PBH structure and an active layer with InGaAsP strained MQW(compressive strain of 0.5%, quantum well width of around 40Å) is used. Its high temperature light output characteristic, FMSR and high-speed modulation characteristic will be explained related with parameters, a resonator length of L, a detuned quantity $\Delta\lambda25°C$ at 25°C and number of quantum wells Nw. As shown in FIG.6, the active layer comprising strained quantum well layers 12 and barrier layers 13, DC-PBH structure 14 and $\lambda/4$ shift diffraction grating 15 are formed on a n-InP substrate 11. On the back surface, a n-electrode 16 is formed and on the front surface non-reflecting coating 17 and p-pad electrodes 16 are formed. L represents a resonator length.

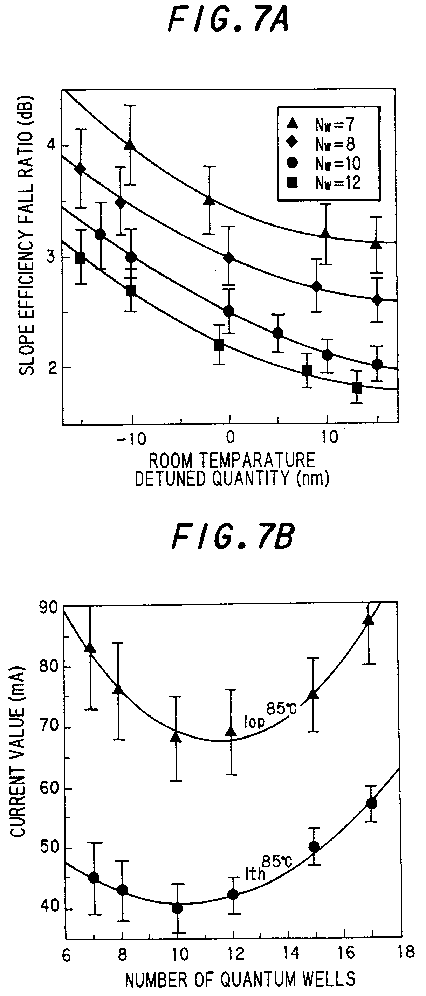

FIG.7A shows a slope efficiency fall ratio $\Delta\eta85°C$ to the temperature rise of 25 to 85°C in L=450 $\mu$m, related with parameters, $\Delta\lambda25°C$ and Nw, where plotted marks and tolerance lines indicate averages and dispersions of devices, respectively and are used as well in following figures for showing device characteristics. If Nw is constant, the bigger $\Delta\lambda25°C$ is, i.e., the longer than a gain peak wavelength the Bragg wavelength is, the less $\Delta\eta85°C$ is. This is because even when $\Delta\lambda$ is shifted to the negative side due to the temperature rise the bigger $\Delta\lambda25°C$ is the less the absolute value is and therefore a sufficient optical gain can be obtained at the Bragg wavelength. If $\Delta\lambda25°C$ is constant, the bigger Nw is the less $\Delta\eta85°C$ is. This is because the bigger Nw is the bigger a light confinement factor $\Gamma w$ to the quantum well layer is, thereby giving a sufficient optical gain even at high temperature, and because the bigger Nw is the less the injected carrier density per a quantum well layer is even when the injection current is equal, thereby suppressing the reduction in optical gain that is significant at high temperature.

Meanwhile, as described below, to obtain FMSR sufficient for the long-distance high-speed transmission in the temperature range of -40 to +85°C, it is required that the room temperature detuned quantity $\Delta\lambda25°C$ be less than +15 nm. Considering this point, to obtain a product yield, for example, more than 50% sufficient to the condition of $\Delta\eta85°C \leq 3dB$, it is required that Nw be more than 8 or $\Gamma w$ be more than 3%. Here, by increasing Nw or $\Gamma w$, $\Delta\eta85°C$ of the high temperature characteristics can be improved. However, if Nw or $\Gamma w$ increases beyond a certain degree, there is a problem that the optical waveguide loss of device is increased, thereby increasing the threshold current Ith, reducing the slope efficiency $\eta$ and increasing the operating current Iop when outputting a constant light power.

FIG.7B shows the Nw dependencies of the threshold current Ith85°C and the operating current Iop85°C in 5mW output at 85°C in a device with L=450 $\mu$m and $\Delta\lambda25°C=0$ nm. Both Ith85°C and Iop85°C significantly increase over Nw=10, and to obtain a product yield sufficient to the condition of Ith85°C$\leq$50mA and Iop85°C$\leq$80mA, for example, more than 50%, it is needed that Nw be less than 15 or $\Gamma w$ be less than 10%.

Accordingly, to obtain a product yield more than 50% sufficient to the condition of $\Delta\eta85°C\leq3dB$, Ith85°C$\leq$50mA and Iop85°C$\leq$80mA while suppressing the slope efficiency fall ratio $\Delta\eta$ at high temperature and preventing the threshold current and operating current at high temperature from increasing, it is required that Nw be 8 to 15 or $\Gamma$ be 3 to 10%, preferably Nw=10 to 12, $\Gamma w=5$ to 8%.

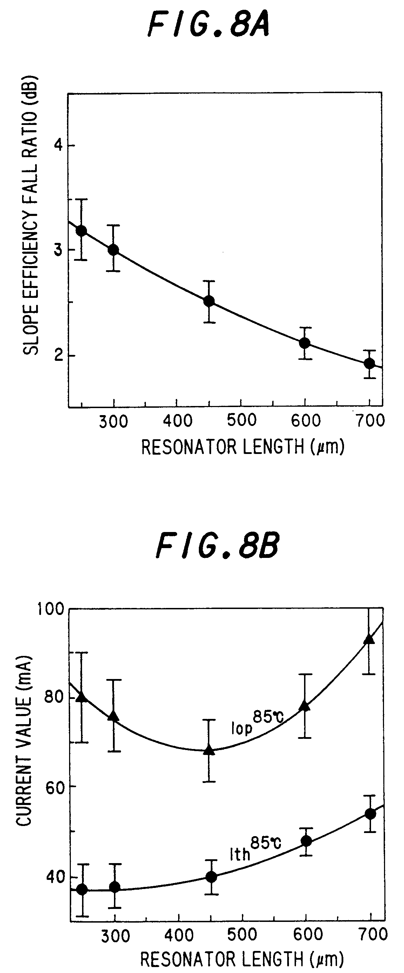

Next, taking the case of a device with Nw=10, $\Delta\lambda25°C=0$ nm, the resonator length L dependency of high temperature light output characteristic will be explained. FIG.8A shows the L dependency of $\Delta\eta85°C$ in the device with Nw=10, $\Delta\lambda25°C=0$ nm . The bigger L is the better $\Delta\eta85°C$ is improved. To obtain a product yield more than 50% to the condition of $\Delta\eta 85°C\leq 3dB$, a resonator length of more than 300 μm is needed. Thus, the longer the resonator length is, the more the leak current in the current constriction part at high temperature and the carrier overflow in the active layer is reduced and the more the maximum light output increases, due to the reduction in current density. However, when the resonator length is lengthened, due to the increase in the optical waveguide loss and injection current density, it may cause a problem of increasing the threshold current Ith, reducing the slope efficiency η and increasing the operating current Iop when outputting a constant light power. Namely, as shown in FIG.8B, since Ith85°C and Iop85°C are significantly increased with the increase in L. Thus, to obtain a product yield sufficient to the condition of Ith85°C≤50mA and Iop85°C≤80mA, it is desired that the resonator length be less than 600 μm, preferably less than 500 μm.

Accordingly, to suppress the slope efficiency fall ratio $\Delta\eta$ at high temperature and prevent the threshold current and operating current at high temperature from increasing, it is required that the resonator length L be 300 to 600 μm, preferably 400 to 500 μm.

Described above are the device designing parameters necessary for obtaining the high temperature light output characteristics. Below, device parameters necessary for achieving a stable single axis mode oscillation in a wide temperature range -40 to 85°C will be explained.

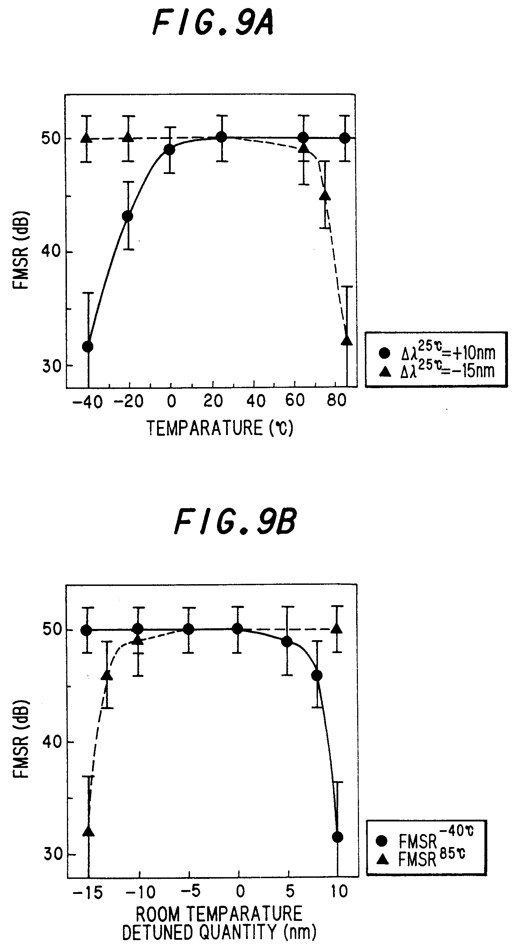

FIG.9A shows the temperature-dependency of FMSR in a device with L=450 μm and Nw=10($\Gamma$w=6%), using $\Delta\lambda 25°C$ as a parameter. In a device with $\Delta\lambda 25°C=+10$ nm, FMSR is deteriorated due to the increase in the absolute value of detuned quantity at lower temperatures, in a device with $\Delta\lambda 25°C=-15$ nm, FMSR is deteriorated due to the increase in the absolute value of detuned quantity at higher temperatures. FIG.9B shows the $\Delta\lambda 25°C$ dependency of FMSR at -40 and +85°C. As seen from FIG.9B, to obtain FMSR sufficient to achieve a long-distance high-speed transmission in the temperature range of -40 to +85°C, for example, FMSR more than 30 dB in case of 622 Mb/s and 50 km transmission, it is required that $\Delta\lambda 25°C$ be +10 to -15 nm.

Meanwhile, the deterioration of FMSR with the increase in the absolute value of detuned quantity becomes significant with the increase in Nw or $\Gamma$w. The allowable range of $\Delta\lambda 25°C$ to assure like FMSR in the temperature range of -40 to +85°C is limited to +15 to -18 nm in a device with Nw=8, +8 to -12 nm in a device with Nw=12 and +6 to -10 nm in a device with Nw=15. Thus, to assure FMSR sufficient for the wide temperature range and $\Delta\lambda 25°C$, Nw is desirably 15 or less.

Accordingly, to obtain a 1.3 μm InGaAsP $\lambda$/4 shift strained MQW-LD which can be used as a light source for long-distance high-speed optical communication system which requires a transmission rate of more than several hundreds Mb/s( normally 622.08 Mb/s or 2.48832 Gb/s) and a transmission distance of more than several tens km( normally more than 40 km) in the wide temperature range of -40 to +85°C and to produce it with a high product yield and low cost, it is necessary for it to satisfy a resonator length of 300 to 600 μm, a detuned quantity at room temperature of -15 to +15 nm and a quantum well layer number of 8 to 15 or a light confinement factor $\Gamma$w to the quantum well layer of 3 to 10%.

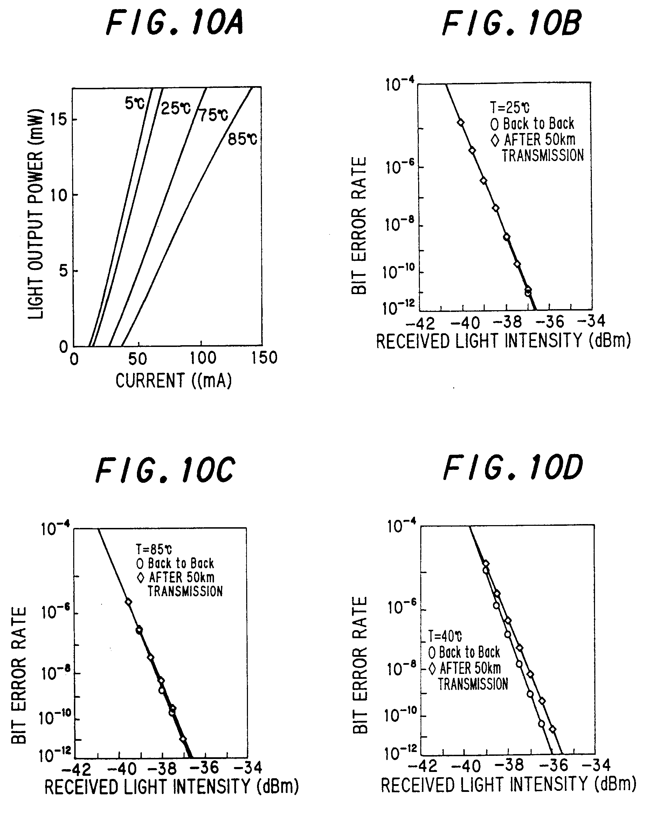

FIGS.10A to 10D show the temperature characteristic of current-light output power characteristics and typical examples of 622 Mb/s and 50 km transmission characteristics at -40°C, +25°C and +85°C, in a $\lambda$/4 shift strained MQW-LD with L=450 μm, $\Delta\lambda 25°C=0$ nm and Nw=10($\Gamma$w=6%) as an example of a device which is fabricated within the designing parameters as defined above. As a result, it can achieve an excellent high temperature light output characteristic, i.e., a threshold current of 37 mA, an operating current in 5mW output of 67 mA and a slope efficiency fall ratio from 25°C of 2.3 dB, even at 85°C and a good transmission characteristic that has no error floor until a code error ratio of under $10^{-11}$ in the wide temperature range of -40°C to +85°C.

The $\lambda$/4 shifted DFB-LD is advantageous that it can obtain a stable single axis mode oscillation at a Bragg wavelength near the center of stop band width even at a high transmission rate of more than several Gb/s, for example, 2.48832 Gb/s. However, in a device applied to such high-speed transmission, a sufficient high-speed response characteristic is required, where a resonator length L, a quantum well number Nw or a light confinement factor $\Gamma$w to quantum well layer and a detuned quantity $\Delta\lambda$ highly affects the high-speed response characteristic, therefore the parameters to achieve a practically sufficient light output characteristic in the temperature range of -40 to 85°C and a long distance transmission with a transmission rate of more than several Gb/s will be further limited.

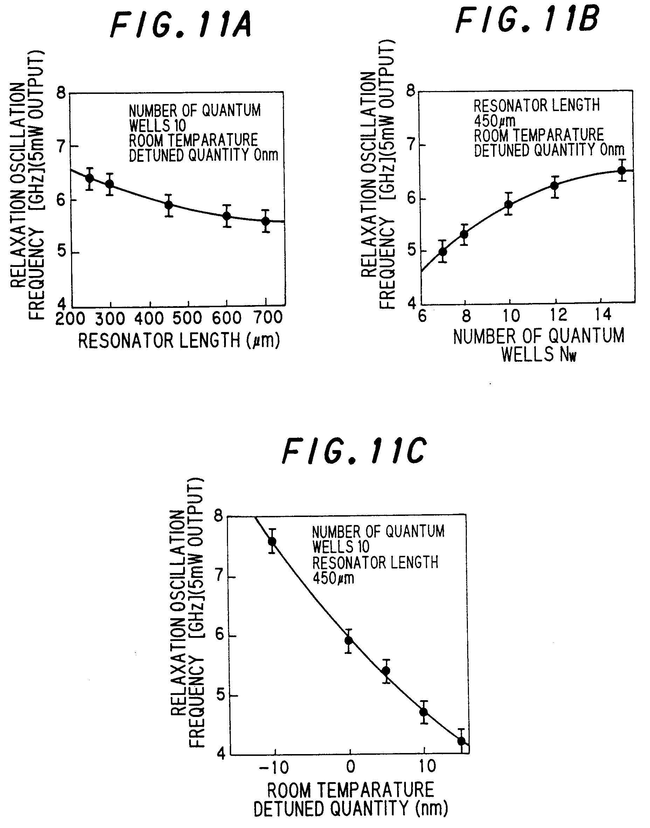

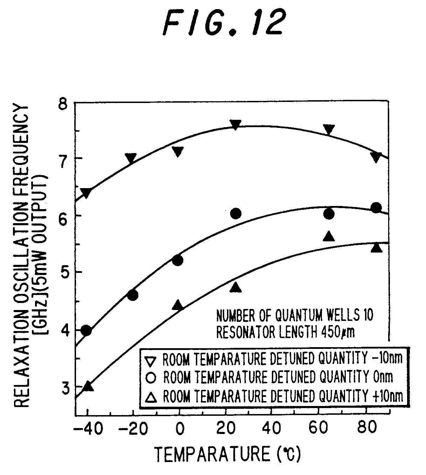

FIGS.11A to 11D show the dependency of a relaxation oscillation frequency fr at 25°C and in a light output of 5mW on a resonator length L, a quantum well number Nw and a detuned quantity $\Delta\lambda 25°C$ at 25°C. The less L is, the bigger Nw or $\Gamma$w is or the less $\Delta\lambda 25°C$ is, the higher the high-speed response characteristic is enhanced. FIG.12 shows the temperature-dependency of the relaxation oscillation frequency fr in a light output of 5mW. In a low temperature region, since $\Delta\lambda$ is shifted to the positive side, the high-speed response characteristic is reduced. Considering this point, it is desirable for $\Delta\lambda 25°C$ which highly affects the high-speed response of device to be less than 0. Accordingly, to obtain a 1.3 μm InGaAsP $\lambda$/4 shift strained MQW-LD which can be used as a light source for long-distance high-speed optical communication system which requires a transmission rate of more than several hundreds Mb/s( normally 2.48832 Gb/s) and a transmission distance of more than several tens km( normally more than 40 km) in the wide temperature range of -40 to +85°C and to produce it with a high product yield and low cost, it is necessary for it to satisfy a resonator length of 300 to 500 μm, a

detuned quantity at room temperature of -15 to 0 nm and a quantum well layer number of 10 to 15 or a light confinement factor $\Gamma$w to the quantum well layer of 10 to 15%.

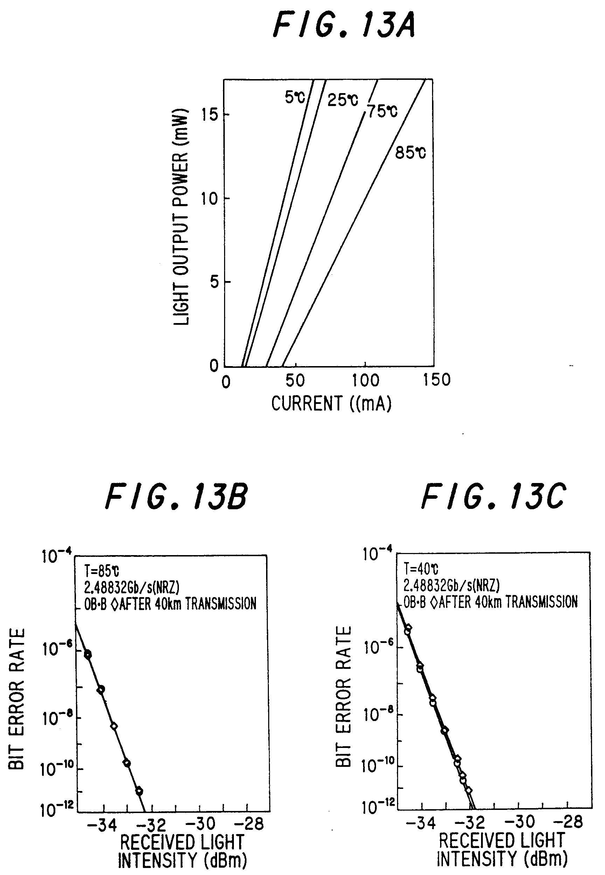

FIGS.13A to 13C show the temperature characteristic of current-light output power characteristics and typical examples of 2.48832 Gb/s and 40 km transmission characteristics at -40°C and +85°C, in a $\lambda$/4 shift strained MQW-LD with L=450 $\mu$m, $\Delta\lambda$25°C=- 8 nm and Nw=12($\Gamma$w=6.6%) as an example of a device which is fabricated within the designing parameters as defined above. As a result, it can achieve an excellent high temperature light output characteristic, i.e., a threshold current of 42 mA, an operating current in 5mW output of 72 mA and a slope efficiency fall ratio from 25°C of 2.3 dB, even at 85°C and a good transmission characteristic that has no error floor until a code error ratio of under $10^{-11}$ in the wide temperature range of -40°C to +85°C.

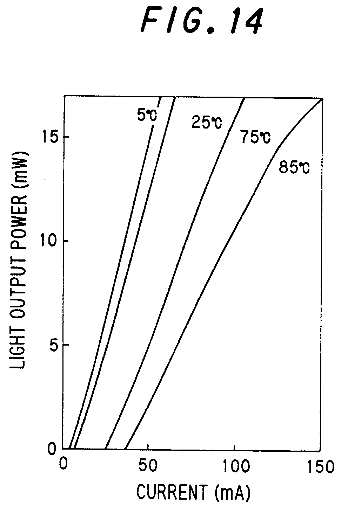

Next, a laser diode device in the second preferred embodiment according to the invention will be explained. In the second embodiment, employed are an active layer with the same InGaAsP strained MQW structure as in the first embodiment which is formed on a p-InP substrate and a current constriction structure with PBH structure which is buried and grown by metal organic vapor phase epitaxy(hereinafter referred to as 'MOVPE'). FIG.14 shows the temperature characteristic of current-light output power characteristics in a $\lambda$/4 shift strained MQW-LD with L=450 $\mu$m, $\Delta\lambda$25°C=0 nm and Nw=10($\Gamma$w=6%) in the second embodiment. In MOVPE, compared with the first embodiment in which the DC-PBH structure is formed by liquid phase epitaxy(hereinafter referred to as 'LPE'), the controllability and reproducibility in the fabrication of the current constriction structure can be improved, further, as seen from FIG.14, the threshold current at room temperature or less can be effectively reduced. However, the threshold current, slope efficiency fall ratio and operating current in 5mW output are similar to those of the DC-PBH structure device in the first embodiment. Further, FMSR and high-speed modulation characteristic does not significantly change due to the difference of the current constriction structure and the growth technique thereof. The resonator length, room temperature detuned quantity and number of quantum wells(or light confinement factor) most predominantly affect the device characteristic.

For that reason, in the case that employs a current constriction structure with PBH structure which is buried and grown by MOVPE or the other current constriction structure or ridge waveguide type LD and an active layer with InGaAsP strained MQW, to obtain a 1.3 $\mu$m InGaAsP $\Delta\lambda$ shift strained MQW-LD which can be used as a light source for long-distance high-speed optical communication system which requires a transmission rate of more than several hundreds Mb/s( normally 622.08 Mb/s or 2.48832 Gb/s) and a transmission distance of more than several tens km( normally more than 40 km) in the wide temperature range of -40 to +85°C and to produce it with a high product yield and low cost, it is necessary for it to satisfy a resonator length of 300 to 600 $\mu$m, a detuned quantity at room temperature of -15 to +15 nm and a quantum well layer number of 8 to 15 or a light confinement factor $\Gamma$w to the quantum well layer of 3 to 10%.

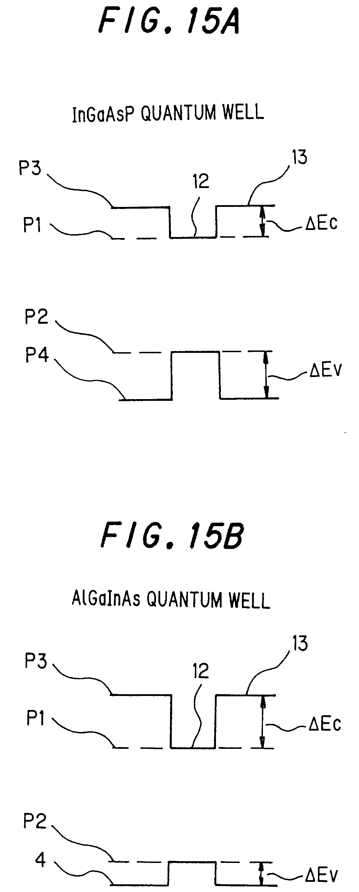

A laser diode device in the third preferred embodiment according to the invention will be explained below. The third embodiment uses a ridge waveguide type $\lambda$/4 shifted DFB-LD which is provided with an active layer with a AlGaInAs strained MQW structure. As shown in FIGS.15A and 15B, which shows a strained quantum well layer 12, conduction band potentials P1, P2 of quantum well layer in a barrier layer 14, conduction band potentials P3, P4, a band discontinuous quantity $\Delta$Ec of conduction band and a band discontinuous quantity $\Delta$Ev of valence band, in the AlGaInAs active layer, the band discontinuous quantity $\Delta$Ec of conduction band on hetero-junction interface is greater than the InGaAsP hetero interface with the same bandgap difference. Therefore, the confinement to the quantum well layer by electron which has effective mass greater than hole is strengthened, thereby decreasing the carrier overflow at high temperature. As a result, as compared with the InGaAsP LD, the deterioration of light output characteristic can be reduced.

Accordingly, the limitations of the resonator length L, detuned quantity $\Delta\lambda$ and number of quantum wells Nw or light confinement factor $\Gamma$w which are required to achieve a desired light output characteristic at high temperature can be relaxed, compared with the $\lambda$/4 shifted DFB-LD in the first and second embodiments in which the active layer employs InGaAsP strained MQW. Thus, to obtain a semiconductor laser device which can be used as a light source for long-distance high-speed optical communication system which requires a transmission rate of more than several hundreds Mb/s( normally 622.08 Mb/s or 2.48832 Gb/s) and a transmission distance of more than several tens km( normally more than 40 km) in the wide temperature range of -40 to +85°C and to produce it with a high product yield and low cost, it is necessary for it to satisfy a resonator length of 250 to 600 $\mu$m, a detuned quantity at room temperature of -20 to +15 nm and a quantum well layer number of 4 to 15 or a light confinement factor $\Gamma$w to the quantum well layer of 2 to 10%. Furthermore, to obtain a semiconductor laser device which can be used as a light source for long-distance high-speed optical communication system which requires a transmission rate of more than several hundreds Mb/s( normally 2.48832 Gb/s) and a transmission distance of more than several tens km( normally more than 40 km) in the wide temperature range of -40 to +85°C and to produce it with a high product yield and low cost, it is necessary for it to satisfy a resonator length of 250 to 500 $\mu$m, a detuned quantity at room temperature of -20 to +0 nm and a quantum well layer number of 5 to 15 or a light confinement factor $\Gamma$w to the quantum well layer of 3 to 10%.

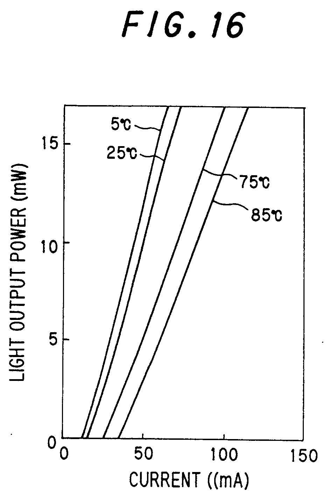

FIG.16 shows a typical example of the temperature characteristic of current-light output power characteristics in a λ/4 shifted DFB-LD with L=300 μm, $\Delta\lambda 25°C=-6$ nm and Nw=10(Γw=5%) which is provided with the active layer with the AlGaInAs strained MQW structure. As a result, it can achieve an excellent high temperature light output characteristic, i.e., a threshold current of 35 mA, an operating current in 5mW output of 60 mA and a slope efficiency fall ratio from 25°C of 1.2 dB, even at 85°C and a good transmission(2.48832 Gb/s, 40 km) characteristic that has no error floor until a code error ratio of under $10^{-11}$ in the wide temperature range of -40°C to +85°C.

Although the invention has been described with respect to specific embodiment for complete and clear disclosure, the appended claims are not to be thus limited but are to be construed as embodying all modification and alternative constructions that may be occurred to one skilled in the art which fairly fall within the basic teaching here is set forth.

## Claims

1. A 1.3 μm band λ/4 shifted distributed-feedback type laser diode device, comprising:

    an active layer with $In_{1-x}GaxAs_{1-y}Py$ (0≤x<1, 0≤y<1) strained multiple quantum wells;

    wherein a resonator length of said laser diode device is 300 to 600 μm, a detuned quantity at room temperature is -15 to +15 nm and, either a quantum well number is 8 to 15 or a light confinement factor to said quantum well layers is 3 to 10%.

2. A 1.3 μm band λ/4 shifted distributed-feedback type laser diode device, comprising:

    an active layer with $In_{1-x}GaxAs_{1-y}Py$ (0≤x<1, 0≤y<1) strained multiple quantum wells;

    wherein a resonator length of said laser diode device is 400 to 500 μm, a detuned quantity at room temperature is -10 to +10 nm and, either a quantum well number is 10 to 12 or a light confinement factor to said quantum well layers is 5 to 8%.

3. A 1.3 μm band λ/4 shifted distributed-feedback type laser diode device, comprising:

    an active layer with AlGaInAs strained multiple quantum wells;

    wherein a resonator length of said laser diode device is 250 to 600 μm, a detuned quantity at room temperature is -20 to +15 nm and, either a quantum well number is 5 to 15 or a light confinement factor to said quantum well layers is 2 to 10%.

4. A 1.3 μm band λ/4 shifted distributed-feedback type laser diode device, comprising:

    an active layer with AlGaInAs strained multiple quantum wells;

    wherein a resonator length of said laser diode device is 300 to 500 μm, a detuned quantity at room temperature is -15 to +10 nm and, either a quantum well number is 6 to 12 or a light confinement factor to said quantum well layers is 2.5 to 8%.

# FIG.1 PRIOR ART

# *FIG.2A  PRIOR  ART*

# *FIG.2B  PRIOR  ART*

# FIG.3A
## PRIOR ART

# FIG.3D
## PRIOR ART

# FIG.3B
## PRIOR ART

# FIG.3C
## PRIOR ART

## FIG.4A PRIOR ART

## FIG.4B PRIOR ART

## FIG.4C PRIOR ART

## FIG.5A PRIOR ART

## FIG.5B PRIOR ART

## FIG.5C PRIOR ART

# FIG.6

11 n-InP SUBSTRATE

12 STRAINED MQW LAYER

13 BAFFER LAYER

14 DC-PBH CURRENT CONSTRICTION STRUCTURE

15 λ/4 SHIFT DIFFRACTION GRATING

16 n-ELECTRODE

17 NON-REFRECTING COATING

18 p-PAD ELECTRODE

EP 0 772 267 A1

## F I G. 7A

## F I G. 7B

## FIG.8A

## FIG.8B

# FIG. 9A

# FIG. 9B

# FIG. 10A

# FIG. 10B

# FIG. 10C

# FIG. 10D

EP 0 772 267 A1

# FIG.11A

# FIG.11B

# FIG.11C

# FIG. 12

# FIG. 13A

# FIG. 13B

# FIG. 13C

# FIG. 14

# FIG. 15A

InGaAsP QUANTUM WELL

# FIG. 15B

AlGaInAs QUANTUM WELL

# FIG. 16

European Patent Office

**EUROPEAN SEARCH REPORT**

Application Number

EP 96 11 7523

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | PROCEEDINGS OF THE 21ST EUROPEAN CONFERENCE ON OPTICAL COMMUNICATION (ECOC'95), 17-21 SEPTEMBER 1995 BRUSSELS BELGIUM, pages 537-540, XP002024696 Y. FURUSHIMA ET AL: "Wide temperature range operation of 1.3 mum strained MQW lambda/4- shifted DFB LD's for 2.5 Gb/s Transmission Modules without Temperature Control" | 1,2 | H01S3/085 H01S3/19 |
| Y | * the whole document * | 3,4 | |
| Y | IEEE JOURNAL OF QUANTUM ELECTRONICS, vol. 30, no. 2, 1 February 1994, pages 511-521, XP000449501 ZAH C -E ET AL: "HIGH-PERFORMANCE UNCOOLED 1.3-UM A1XGAYIN1-X-YAS/INP STRAINED-LAYER QUANTUM-WELL LASERS FOR SUBSCRIBER LOOP APPLICATIONS" * the whole document * | 3,4 | |
| A | JAPANESE JOURNAL OF APPLIED PHYSICS, vol. 33, no. 1B, January 1994, TOKYO JP, pages 811-814, XP002024697 H. MAWATARI ET AL: "Spectral linewidth and linewidth enhancement factor in 1.5 mum modulation doped strained mqw lasers" * figures 2,5 * | 1-4 | **TECHNICAL FIELDS SEARCHED** (Int.Cl.6) H01S |
| A | IEEE PHOTONICS TECHNOLOGY LETTERS, vol. 3, no. 4, 1 April 1991, pages 305-307, XP000227562 KITAMURA M ET AL: "HIGH-PERFORMANCE 1.5 UM MULTIPLE-QUANTUM-WELL DFB-DC-PBH-LD'S AT 30 MW OUTPUT POWER FOR GB/S RANGE COHERENT SYSTEMS" * the whole document * | 1-4 | |

-/--

The present search report has been drawn up for all claims

| Place of search | Date of completion of the search | Examiner |
|---|---|---|
| THE HAGUE | 6 February 1997 | Claessen, L |

**European Patent Office**

## EUROPEAN SEARCH REPORT

Application Number

EP 96 11 7523

### DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| A | NEC RESEARCH AND DEVELOPMENT, vol. 33, no. 3, 1 July 1992, pages 354-363, XP000327430 HIROHITO YAMADA ET AL: "EXTREMELY LOW OPERATING CURRENT = 1.3 UM MULTIPLE-QUANTUM-WELL LASER DIODES" * figure 7 * | 1-4 | |
| | | | **TECHNICAL FIELDS SEARCHED** (Int.Cl.6) |

The present search report has been drawn up for all claims

| Place of search | Date of completion of the search | Examiner |
|---|---|---|
| THE HAGUE | 6 February 1997 | Claessen, L |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)